# EUROPEAN PATENT APPLICATION

(11) **EP 4 492 479 A1**
(43) Date of publication of application: **15.01.2025**
(21) Application number: 23788125.5
(22) Date of filing: 20.03.2023
(51) Int. Cl.: H01L 33/50, G02B 5/20, H01L 33/04, H01L 33/48, H01L 33/58

(54) **LIGHT-EMITTING DEVICE**

(30) Priority: 13.04.2022 JP 2022066606
(71) Applicant: Kyoto University, Kyoto-shi, Kyoto 606-8501 (JP); Stanley Electric Co., Ltd., Meguro-ku Tokyo 153-8636 (JP)
(72) Inventor: NODA, Susumu, Kyoto-shi, Kyoto 606-8501 (JP); ISHIZAKI, Kenji, Kyoto-shi, Kyoto 606-8501 (JP); MURAI, Shunsuke, Kyoto-shi, Kyoto 606-8501 (JP); KASHIWAGI, Hiroyuki, Tokyo 153-8636 (JP); KAWAKAMI, Yasuyuki, Tokyo 153-8636 (JP); MAEMURA, Yosuke, Tokyo 153-8636 (JP)
(74) Representative: Pritzlaff, Stefanie Lydia
(86) International application number: PCT/JP2023/010930
(87) International publication number: WO 2023/199703

(57) **Abstract**

A light-emitting device includes: a semiconductor light-emitting structure layer configured to have a photonic crystal layer; and a nanoantenna phosphor configured to be placed on an emission surface of the semiconductor light-emitting structure layer and to include a wavelength converter configured to convert a wavelength of light emitted from the semiconductor light-emitting structure layer to generate wavelength-converted light and an antenna array configured to have a plurality of nanoantennas periodically arranged on the wavelength converter.

## Description

### Technical Field

The present invention relates to a light-emitting device, and more particularly, to a light-emitting device including a light-emitting element having a photonic crystal and a phosphor.

### Background Art

In recent years, efforts toward autonomous driving of vehicles, such as automobiles or moving objects, have progressed rapidly, and requirements for lighting equipment, such as headlamps, have also been changed. For example, headlamps are required to have value not only as a single lamp but also as a lamp system into which sensors and the like have been incorporated. For example, some vehicle headlamps in which light emitting diode (LED) elements are disposed in parallel to increase output are used. However, there is a problem in that it is difficult to secure a space for installing the sensors and the like.

In general, spontaneous emission LEDs have a Lambertian light emission distribution, and the light distribution is widely spread. As a result, loss occurs due to light that deviates from a lens in the headlamp. It is necessary to increase the size of the lens (that is, to increase an aperture ratio NA) in order to reduce the loss of light and to further increase the amount of light. However, this is not preferable from the viewpoint of the space of the headlamp. It is necessary to narrow the angle of the light emission distribution of an LED light source in order to increase the amount of incorporation of LEDs without changing the NA of the lens.

As a technique for forming a small-sized and narrow-angle white light source, a configuration is disclosed in which a laser beam is emitted to a phosphor having nanoantennas formed on its surface.

For example, Patent Literature 1 discloses an illumination device in which photons from a photon emitter are emitted from a plasmonic antenna array. In addition, Patent Literature 2 discloses a wavelength conversion device including a wavelength converter that converts a wavelength of incident laser light and an antenna array that is formed on an emission surface of the wavelength converter.

However, there is still a demand for a light source that has a narrow-angle light distribution and high light output.

### Summary of Invention

### Technical Problem

An object of the present invention is to provide a light-emitting device that has a narrow-angle light distribution characteristic and emits mixed-color light with high efficiency and high output.

### Solution to Problem

According to a first embodiment of the present invention, there is provided a light-emitting device comprising: a semiconductor light-emitting structure layer configured to have a photonic crystal layer; and a nanoantenna phosphor configured to be placed on an emission surface of the semiconductor light-emitting structure layer and to include a wavelength converter configured to convert a wavelength of light emitted from the semiconductor light-emitting structure layer to generate wavelength-converted light and an antenna array configured to have a plurality of nanoantennas periodically arranged on the wavelength converter.

### Citation List

### Patent Literatures

Patent Literature 1: Japanese Patent No. 6381645
Patent Literature 2: Japanese Patent No. 6789536

### Brief Description of Drawings

FIG. 1A is a plan view schematically illustrating an upper surface of a light-emitting device 10 according to a first embodiment of the present invention.
FIG. 1B is a cross-sectional view schematically illustrating a cross-sectional structure taken along a line A-A illustrated in FIG. 1A.
FIG. 2 is a view illustrating results of simulating incident angle (θ) dependence of reflectivity of an optical filter 40.
FIG. 3A is a view illustrating a dispersion relationship in which a horizontal axis is a wave number kx (= ksinθ) and a vertical axis is a normalized frequency a/λ.
FIG. 3B is an enlarged view illustrating a maximum value portion in a TE0 mode.
FIG. 4A is a cross-sectional view illustrating a nanoantenna phosphor 30.
FIG. 4B is a top view illustrating the nanoantenna phosphor 30.
FIG. 5A is a graph illustrating a simulation result of a relationship between an emission angle (θem) of an antenna array 32 and a wavelength when a period P is 360 nm.
FIG. 5B is a graph illustrating a simulation result of the relationship between the emission angle (θem) of the antenna array 32 and the wavelength when the period P is 400 nm.
FIG. 5C is a graph illustrating a simulation result of the relationship between the emission angle (θem) of the antenna array 32 and the wavelength when the period P is 440 nm.
FIG. 5D is a graph illustrating a simulation result of the relationship between the emission angle (θem) of the antenna array 32 and the wavelength when the period P is 480 nm.
FIG. 6A is a view illustrating light distribution characteristics of blue light from an LED structure layer 20.
FIG. 6B is a view illustrating light distribution characteristics of fluorescence (yellow light) from the nanoantenna phosphor 30.
FIG. 6C is a view illustrating light distribution characteristics of white light from the light-emitting device 10.
FIG. 7 is a view schematically illustrating narrow-angle LED light generated by an LED structure layer 20.
FIG. 8 is a cross-sectional view schematically illustrating a cross-sectional structure of a light-emitting device 50 according to a second embodiment of the present invention.

### Description of Embodiments

Hereinafter, preferred embodiments of the present invention will be described. However, these embodiments may be appropriately modified and combined. In addition, in the following description and the accompanying drawings, substantially the same or equivalent parts will be denoted by the same reference numerals.

### [First Embodiment]

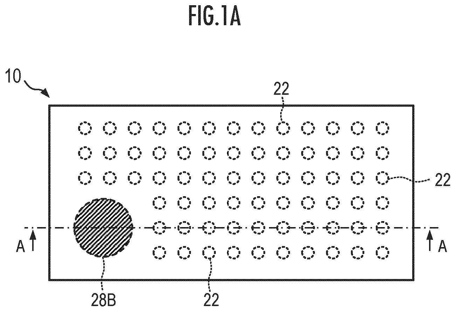

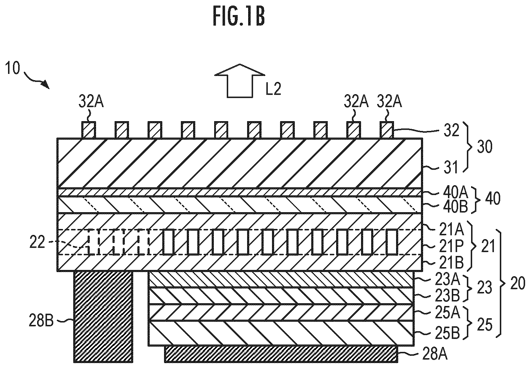

FIG. 1A is a plan view schematically illustrating an upper surface of a light-emitting device 10 according to a first embodiment of the present invention, and FIG. 1B is a cross-sectional view schematically illustrating a cross-sectional structure taken along a line A-A illustrated in FIG. 1A.

As illustrated in FIGS. 1A and 1B, the light-emitting device 10 includes a semiconductor light-emitting structure layer 20, a nanoantenna phosphor 30, and an optical filter 40. In the light-emitting device 10 according to the present embodiment, the optical filter 40 is disposed on an emission surface of the semiconductor light-emitting structure layer 20, and the nanoantenna phosphor 30 is disposed on the optical filter 40.

### (1) Semiconductor Light-Emitting Structure Layer

The semiconductor light-emitting structure layer (hereinafter, referred to as an LED structure layer) 20 includes a first semiconductor layer 21 including a photonic crystal layer 21P, an active layer 23, and a second semiconductor layer 25.

In addition, in the present embodiment, a case where the LED structure layer 20 is a nitride-based semiconductor layer (GaN-based semiconductor layer) will be described. However, the LED structure layer 20 may be a semiconductor light-emitting structure layer based on another crystal system that operates as an LED.

Further, the composition, layer thickness, impurities, doping concentration, and the like of each layer in the semiconductor structure layer that will be described below are only examples and are capable of being, for example, appropriately selected and modified according to desired characteristics.

The LED structure layer 20 will be described in detail below with reference to FIGS. 1A and 1B.

The LED structure layer 20 is formed by sequentially growing the active layer 23 and the second semiconductor layer 25 on the first semiconductor layer 21. For example, the LED structure layer 20 is capable of being formed by a metal organic chemical vapor deposition (MOCVD) method, a molecular beam epitaxy (MBE) method, or the like.

The first semiconductor layer 21 includes the photonic crystal layer 21P that is formed on an underlayer 21A made of n-GaN which is an n-type semiconductor layer. The photonic crystal layer 21P is a structure layer which has fine air holes 22 twodimensionally periodically formed in a plane parallel to the first semiconductor layer 21 and whose refractive index periodically changes.

A buried layer 21B that buries the photonic crystal layer 21P is formed on the photonic crystal layer 21P. The buried layer 21B is made of n-GaN which is an n-type semiconductor layer and has a layer thickness of 120 nm.

More specifically, in the present embodiment, the air holes 22 of the photonic crystal layer 21P are disposed at square lattice positions, have a cylindrical shape, and have a lattice constant (period) of 185 nm, a height of 240 nm, and a diameter of 92.5 nm.

Here, when a lattice constant of the photonic crystal is a, an emission wavelength is λ (in a vacuum), and a refractive index of a base is neff, a ≠ mλ/neff (m is a natural number) is satisfied in the case of a square lattice two-dimensional photonic crystal, and a ≠ mλ x 2/(3/2 x neff) (m is a natural number) is satisfied in the case of a triangular lattice two-dimensional photonic crystal.

In addition, in this case, λ is established not only for a peak wavelength but also for any wavelength λw (in a vacuum) within the full width at half maximum (FWHM) of an emission spectrum of the active layer 23. That is, λ is considered to have a range of 445 nm to 455 nm (445 nm ≤ λw ≤ 455 nm) in a case where the peak of the emission spectrum is 450 nm and the full width at half maximum is 10 nm. Preferably, the present invention is a light-emitting element that emits non-resonant LED light. The angle of non-resonant light is narrowed by forming only the photonic crystal satisfying these conditions.

However, even in a case where a = mλ/neff is satisfied in the case of the square lattice two-dimensional photonic crystal and a = mλ x 2/(3/2 x neff) is satisfied in the case of the triangular lattice two-dimensional photonic crystal, the non-resonant light is capable of being changed into the narrow-angle light when the supplied current value is equal to or less than a predetermined value. In this case, it is possible to achieve a light-emitting element that emits non-resonant LED light for a narrow-angle light component (with an emission angle of 20° or less), similarly to a wide-angle light component (with an emission angle of more than 20°), when a power supply (not illustrated) connected to the light-emitting device 10 supplies a current value at which resonant light is not generated.

A light-emitting layer 23A is formed on the first semiconductor layer 21. The light-emitting layer 23A is a multi-quantum well structure layer (hereinafter, referred to as an MQW layer) having a five-layer structure in which GaN barrier layers and InGaN well layers are alternately stacked.

A spacer layer 23B is formed on the light-emitting layer 23A. The spacer layer 23B is made of GaN and has a layer thickness of 6 nm.

The second semiconductor layer 25 is formed on the spacer layer 23B. More specifically, the second semiconductor layer 25 includes an electron blocking layer 25A and a p-GaN layer 25B which is a p-type semiconductor layer formed on the electron blocking layer 25A.

The electron blocking layer 25A is made of AlGaN and has a layer thickness of, for example, 10 nm. The p-GaN layer 25B has a layer thickness of, for example, 116 nm.

Further, in the present specification, a layer including the light-emitting layer 23A and the spacer layer 23B is referred to as the active layer (core layer) 23. In addition, the first semiconductor layer 21 and the second semiconductor layer 25 having the active layer 23 interposed therebetween function as a first cladding layer and a second cladding layer, respectively.

Since the first semiconductor layer (first cladding layer) 21 includes the photonic crystal layer 21P, that is, the air holes 22, the first semiconductor layer 21 has a smaller refractive index than the base semiconductor (GaN in the present embodiment). Therefore, the effective refractive index of the first semiconductor layer 21 is smaller than the effective refractive index of the active layer (core layer) 23.

In addition, the electron blocking layer 25Ais made of a semiconductor (AlGaN in the present embodiment) having a wider band gap and a smaller refractive index than the active layer 23 (that is, the spacer layer 23B of the active layer 23), and the effective refractive index of the second semiconductor layer (second cladding layer) 25 is smaller than the effective refractive index of the active layer 23.

The first semiconductor layer 21 and the second semiconductor layer 25 have the same function as, for example, a cladding of an optical fiber, that is, a function of confining light guided in the active layer (core layer) 23. In addition, the first semiconductor layer 21 may include a plurality of semiconductor layers having different compositions. Further, the second semiconductor layer 25 may include a plurality of semiconductor layers having different compositions.

Furthermore, the first semiconductor layer 21 is an n-type semiconductor layer, and the second semiconductor layer 25 is a p-type (a conductivity type opposite to the conductivity type of the first semiconductor layer 21) semiconductor layer. However, the first semiconductor layer 21 and the second semiconductor layer 25 may have an i-layer or an undoped layer. For example, the electron blocking layer 25A in the second semiconductor layer 25 may be configured as an undoped layer.

A p-electrode 28A is provided on the p-GaN layer 25B. The p-electrode 28A is formed, for example, as a Ni/Au structure (Au is a surface layer) that includes nickel (Ni) formed on the p-GaN layer 25B and gold (Au) formed on the Ni.

In addition, a metal layer that is in ohmic contact with the p-GaN layer 25B is capable of being used as the p-electrode 28A. For example, the p-electrode 28A has a configuration using an ITO electrode/an Ag reflective film with high reflectivity. In addition, a semiconductor layer (for example, a highly doped layer) that is capable of easily coming into ohmic contact with the metal layer may be provided on the p-GaN layer 25B.

In addition, an n-electrode 28B is provided on an exposed surface of the first semiconductor layer 21 in which the buried layer 21B is partially exposed by etching. The n-electrode 28B is in ohmic contact with the first semiconductor layer 21. The n-electrode 28B has, for example, an aluminum (Al)/platinum (Pt)/Au structure (Au is a surface layer).

As illustrated in FIG. 1A, the light-emitting device 10 is placed on a substrate or a block provided with a wiring circuit, with the p-electrode 28A and the n-electrode 28B facing downward. Light is emitted by the light-emitting device 10 by applying a current between the p-electrode 28A and the n-electrode 28B.

### (2) Optical Filter

In the light-emitting device 10 according to the present embodiment, the optical filter 40 is inserted between the emission surface of the LED structure layer 20 and an incident surface S1 of the nanoantenna phosphor 30. The optical filter 40 is provided to be in close contact with the emission surface of the LED structure layer 20 and the incident surface S1 of the nanoantenna phosphor 30.

In the optical filter 40, a filter film 40A, which is a dichroic mirror, is formed on a sapphire substrate 40B which is a translucent substrate. The filter film 40A is capable of being formed as, for example, a multilayer film (SiO₂/NbO₅ film) in which SiO₂ and NbO₅ are alternately stacked, a SiO₂/TiO₂ multilayer film, or the like.

The optical filter 40 is configured as a short pass filter (SPF) that transmits light (blue light) emitted from the LED structure layer 20 and reflects wavelength-converted light (yellow light) from a phosphor plate 31.

First, an incident angle on the optical filter 40 at which the light emitted from the LED structure layer 20 is efficiently incident on the nanoantenna phosphor 30 will be described.

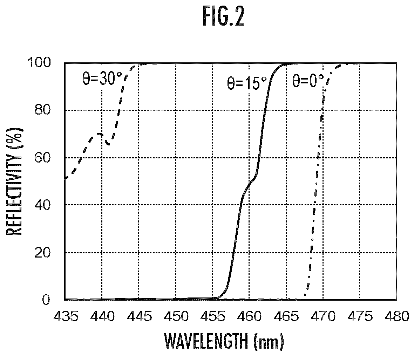

FIG. 2 is a view illustrating the results of simulating the incident angle (Θ) dependence of the reflectivity of the optical filter 40. FIG. 2 illustrates the reflectivity when the incident angle θ of light incident on the optical filter 40 is 30°, 15°, and 0°. In addition, here, 450 nm ± 5 nm is considered as the emission wavelength (λ) of the LED structure layer 20 that emits the narrow-angle light.

When the incident angle θ is 30°, 99% or more of the incident light is reflected by the filter film 40A of the optical filter 40. However, under the condition of θ = 15° (=θth) or less, the reflectivity in the above-described wavelength range is almost 0%, and the blue LED light from the LED structure layer 20 is capable of being efficiently incident on the nanoantenna phosphor 30. That is, it is understood that the LED structure layer 20 having the photonic crystal capable of efficiently emitting narrow-angle light satisfying θth ≤ 15° is effective.

In addition, since the depth of the air hole in the photonic crystal is 100 nm, the photonic crystal has almost no influence on the physical size. Therefore, it is possible to achieve a small-sized narrow-angle white light source of a nanoantenna phosphor using an LED as a light source for the first time.

That is, in the present embodiment, as described above, the emission spectrum of the active layer 23 has a full width at half maximum of 10 nm, and the characteristics of the filter film 40A (SPF) of the optical filter 40 are set such that light within the full width at half maximum is transmitted through the optical filter 40 with a reflectivity of 0%.

As described above, the characteristics of the LED structure layer 20 and the optical filter 40 are set such that light within the full width at half maximum of the emission spectrum of the LED structure layer 20 is transmitted through the optical filter 40 with a reflectivity of 0%.

Further, in the above case, it is preferable that the optical filter 40 has a transmittance of less than 10% for incident light (in the above-described example, blue light) with an incident angle θ of 30° or more at the peak wavelength of the incident light. In addition, it is preferable that the optical filter 40 has a transmittance of 90% or more for incident light with an incident angle θ of 15° or less at the peak wavelength of the incident light.

### (3) Angle Narrowing Structure of Photonic Crystal

Next, a configuration for narrowing the angle of the photonic crystal will be described using a blue LED with a wavelength of λ = 450 nm (a full width at half maximum of 10 nm) as an example.

The band gap of the photonic crystal is calculated. For a calculation method or the like, "Introduction to Photonic Crystals (by Kazuaki Sakoda, Morikita Publishing)" and the like is capable of being referred to as a reference.

In addition, the photonic crystal has the ability to exclude light with a predetermined frequency from the crystal, and the region of the frequency is capable of being freely set. This region is called a photonic band gap.

Here, a dispersion relationship is calculated from photonic band gap calculation. In a case where the refractive index of a medium of the photonic crystal is n = 2.5 (for example, GaN), the atmospheric refractive index of a medium (air) of the air holes in the photonic crystal is n = 1, d/a (where a is a lattice constant (or a period) and d is the diameter of the air hole) is 0.5, and the air holes are disposed in a square lattice, the dispersion relationship in a transverse electric (TE) mode is calculated.

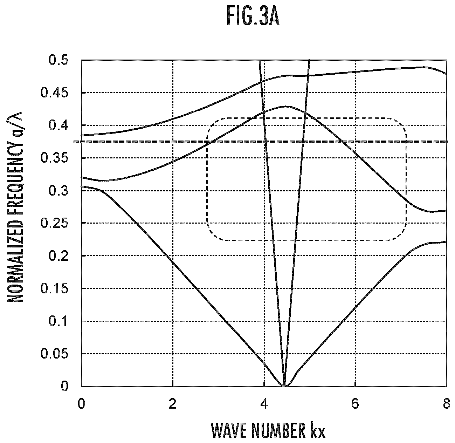

FIG. 3A is a view illustrating the dispersion relationship in which a horizontal axis is a wave number kx(= ksinθ) and a vertical axis is a normalized frequency a/λ. Here, a diffraction angle is θ and the wave number k is 2π/λ. Here, attention is paid to the lowest order TE0 among a plurality of TE modes.

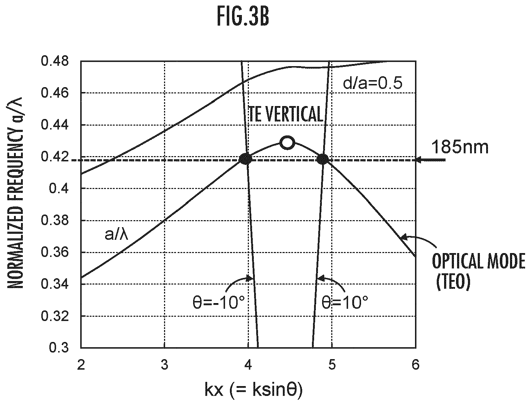

FIG. 3B is an enlarged view illustrating a maximum value portion in the TE0 mode. As illustrated in FIG. 3B, matching the normalized frequency with an optical mode end portion (white circle in FIG. 3B) corresponds to extracting narrow-angle light in a direction of 0°.

Here, the design of the photonic crystal layer 21P is considered assuming that narrow-angle light is allowed up to θ = -15° to 15° (that is, the emission angle is within 30°) in consideration of the incidence of the light on the nanoantenna phosphor 30. In FIG. 3B, diffraction lines obtained at θ = -10° and θ = 10° are plotted as representative design values in a range in which the effect is expected.

A lattice constant design value of 185 nm is obtained from a normalized frequency of 0.415 at locations (black circles in FIG. 3B) satisfying the intersections of the optical mode (TE0) and the diffraction lines. Therefore, the photonic crystal layer 21P may be configured by arranging the air holes 22 in a square lattice with an air hole diameter d of 92.5 nm and a lattice constant a of 185 nm. For example, the photonic crystal layer 21P may be disposed in an in-plane region of 1 mm square.

The arrangement of the air holes in the photonic crystal layer 21P is not limited to the square lattice. The arrangement is capable of being appropriately selected from a triangular lattice, a hexagonal lattice, and the like and is capable of being obtained by the same procedure.

The design value may be determined by the intersection of the diffraction lines and a theoretical value or may be determined by actually manufacturing a plurality of photonic crystal structures with slightly different lattice constants and then setting conditions.

For example, an LED with a photonic crystal is capable of being formed, and photo-luminescence (PL) intensity on the axis is capable of being measured. It is possible to obtain the optimum values of the lattice constant a and the diameter d of the air hole 22 such that the peak value of the intensity is within a desired range.

The angle of the narrow-angle light by the photonic crystal is determined by determining the arrangement of the air holes in the photonic crystal, the lattice constant a, and the diameter d of the air hole 22.

### (4) Nanoantenna Phosphor

### (4.1) Structure of Nanoantenna Phosphor

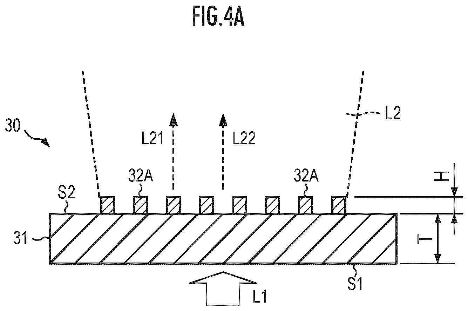

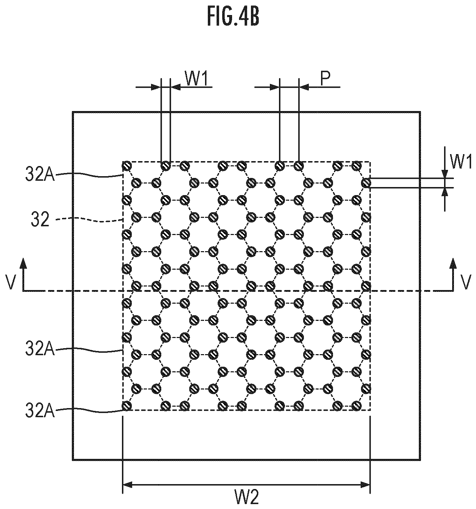

FIG. 4A is a cross-sectional view illustrating the nanoantenna phosphor 30. In addition, FIG. 4B is a top view illustrating the nanoantenna phosphor 30. In addition, FIG. 4A is a cross-sectional view taken along a line V-V of FIG. 4B. As illustrated in FIG. 4A, the nanoantenna phosphor 30 includes the phosphor plate 31 which is a wavelength converter and an antenna array 32 which is formed on the phosphor plate 31 and includes a plurality of nanoantennas 32A (hereinafter, also simply referred to as antennas 32A).

The phosphor plate 31 has the incident surface S1 on which primary light L1, which is light emitted from the LED structure layer 20 and then transmitted through the optical filter 40, is incident and an emission surface S2 from which secondary light L2 is emitted. In the present embodiment, the phosphor plate 31 has a parallel plate shape and has the incident surface S1 as one main surface and the emission surface S2 as the other main surface. That is, the primary light L1 is incident on the incident surface S1 which is the one main surface (rear surface) of the phosphor plate 31 and is emitted from the emission surface S2 which is the other main surface (front surface) of the phosphor plate 31.

The secondary light L2 emitted from the emission surface S2 of the phosphor plate 31 includes wavelength-converted light L21 that has been subjected to the wavelength conversion by the phosphor plate 31 and transmitted light L22 (primary light whose wavelength has not been converted) that has passed through the phosphor plate 31. That is, the phosphor plate 31 converts the wavelength of a portion of the primary light L1 incident on the incident surface S1 to generate the wavelength-converted light L21. Further, in the present example, the phosphor plate 31 is disposed such that the incident surface S1 is perpendicular to the optical axis of the incident light L 1.

In the following description, in some cases, the primary light L1 is referred to as incident light on the phosphor plate 31. In other words, the phosphor plate 31 is configured to include the incident surface S1 and the emission surface S2, to convert the wavelength of the incident light L1 incident on the incident surface S1 to generate the wavelength-converted light L21, and to emit the wavelength-converted light L21 and the transmitted light L22 from the emission surface S2. Further, in the present example, the phosphor plate 31 is disposed parallel to the LED structure layer 20.

In the present embodiment, the phosphor plate 31 is a single-phase ceramic phosphor plate made of yttrium aluminum garnet (YAG:Ce) having cerium as a light emission center.

In addition, as described above, the LED structure layer 20 has an InGaN-based semiconductor as the light-emitting layer, and the primary light L1 is blue light with a wavelength of about 450 nm. Further, the wavelength-converted light L21 is yellow light having a wavelength of about 460 to 750 nm, and the secondary light L2 is white light which is a mixture of the yellow light and the blue light.

Furthermore, various phosphors are capable of being used as the phosphor of the phosphor plate 31, and it is preferable that the phosphor is a single-phase phosphor. This is because the single-phase phosphor is capable of extracting incident excitation light as the narrow-angle light without scattering the incident excitation light.

In addition, it is preferable that the phosphor plate 31 has a thickness T in a range of 40 to 200 µm in consideration of stable whitening (color mixing).

Further, a light reflecting film may be provided on a side surface of the phosphor plate 31. For example, the light reflecting film is a white paint film that is provided on the side surface of the phosphor plate 31. Furthermore, the light reflecting film is capable of being substituted with, for example, a light absorbing film such as a black paint.

Next, the antenna array 32 will be described. In the present embodiment, the antenna array 32 is formed on the emission surface S2 of the phosphor plate 31. The antenna array 32 includes a plurality of antennas 32A disposed with a period P that is larger than the peak wavelength of the light emitted from the LED structure layer 20 and that is approximately equal to the effective wavelength of the wavelength-converted light in the phosphor plate 31.

In the present embodiment, each of the plurality of antennas 32A is a columnar or conical metal protrusion (pillar) that is capable of exciting a surface plasmon. In addition, in the present embodiment, each of the antennas 32A has a cylindrical shape and is made of a material having a plasma frequency in an ultraviolet to visible light region, such as gold (Au), silver (Ag), copper (Cu), platinum (Pt), palladium (Pd), aluminum (Al), or nickel (Ni), or an alloy or laminate including these materials.

In addition, as illustrated in FIG. 4B, in the present embodiment, each of the antennas 32A has substantially the same antenna height H and antenna width (diameter) W1. Further, in a case where the antenna 32A has a columnar or conical shape, the antenna width W1 means the maximum width of the antenna 32A.

In addition, in the present embodiment, the plurality of antennas 32A are arranged in a hexagonal lattice shape with the period P on the emission surface S2 of the phosphor plate 31. Further, the antenna array 32 is formed in a square region that has a vertical and horizontal width (array width) of W2 in a central portion of the emission surface S2.

In the present embodiment, the antenna width W1 is 150 ± 20 nm, and the array width W2 is 6 mm. In addition, the YAG:Ce phosphor has a refractive index of about 1.82 and emits light with a wavelength of 460 nm to 750 nm. Here, an optical wavelength is calculated as (emission wavelength/refractive index).

When each antenna 32A of the antenna array 32 is irradiated with light, the electric field intensity in the vicinity of the antennas 32A is increased by localized surface plasmon resonance on the surface of the antennas 32A. In addition, when the arrangement period P of the antennas 32A is set to be approximately equal to the optical wavelength of the wavelength-converted light L21, the localized surface plasmon resonance of each of adjacent antennas 32A causes resonance through light diffraction, and the electric field intensity is further increased. As a result, the light extraction efficiency of the wavelength-converted light L21 is improved. Further, in the present specification, the term "being approximately equal to the optical wavelength in the phosphor plate 31" means, for example, a wavelength band of 50 nm before and after the emission wavelength band of the phosphor in the phosphor plate 31.

As a result, the wavelength-converted light L21 from the phosphor plate 31 is amplified, has a narrow-angle light distribution (low etendue), and is emitted from the antenna array 32. That is, the antenna array 32 has the function of enhancing light in the phosphor plate 31 and narrowing the emission direction of the secondary light L2 (wavelength-converted light L21).

### (4.2) Angle Narrowing Structure of Nanoantenna Phosphor

Next, a structure for narrowing the angle of the nanoantenna phosphor 30 will be described. Here, since the plasmon resonance occurs in conjunction with the diffraction mode, the period P of the antennas 32A (pillars) in the antenna array 32 is determined by simulating the relationship between the diffraction angle (emission angle) and the wavelength and calculating a region in which light having an emission angle of 30° or less is increased.

Here, the relationship between the emission angle and the wavelength was simulated under the condition that the antenna array 32 having the antennas 32A arranged in a hexagonal lattice was used as a model and the period P was in a range of 360 nm to 480 nm.

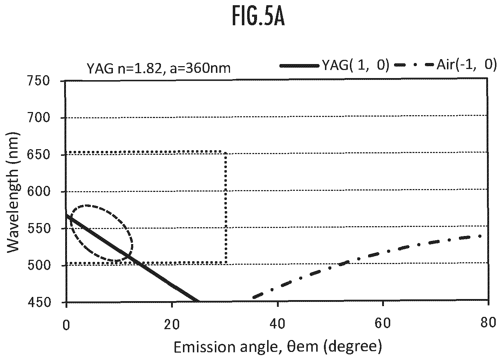

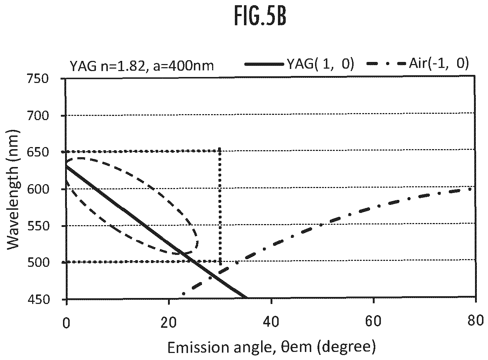

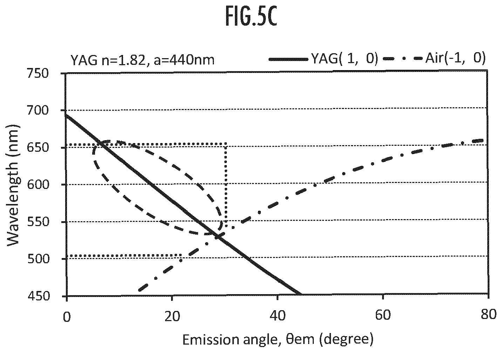

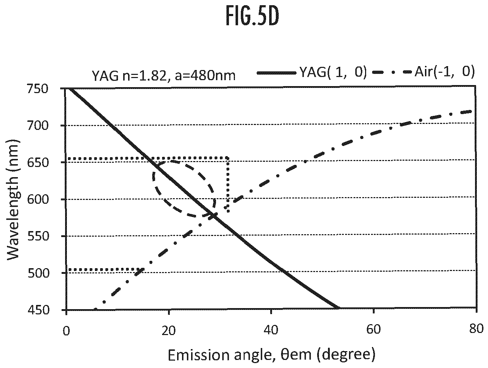

FIGS. 5A to 5D illustrate simulation results of the wavelength of the wavelength-converted light with respect to the emission angle (θem) of the antenna array 32. In addition, the period P is shown as a parameter. More specifically, FIGS. 5A to 5D illustrate a component YAG(1,0) (represented by a solid line in FIGS. 5A to 5D) of a diffraction order (1,0) indicating directivity characteristics and a diffraction order (-1,0) (represented by a one-dot chain line in FIGS. 5A to 5D) in each case where the period P of the antennas 32Ais 360 nm, 400 nm, 440 nm, and 480 nm.

Here, the diffraction order (-1,0) is a line indicating the emission of light from the nanoantenna phosphor 30 to the atmosphere side and is referred to here as Air (-1,0). In a case where a propagation mode is present on the upper left side of an Air (-1,0) line in the drawings, the propagation mode indicates light that is capable of being extracted to the atmosphere side.

In addition, in a case where an optical mode is present in the range of the lower right side of the Air (-1,0) line in the drawings, the light is evanescent light, and it may safely be assumed that the light does not come out of the nanoantenna phosphor 30.

In addition, in FIGS. 5A to 5D, for fluorescence from the phosphor plate 31, light having a wavelength of 500 nm to 650 nm is dominant. Therefore, the condition is that diffracted light within this wavelength range (represented by a dotted line in FIGS. 5A to 5D) is emitted within 30°.

Considering the Air (-1,0) line, it is possible to extract light of a component YAG (1,0) (region surrounded by a broken line) in the range surrounded by the dotted line in order to emit light from the nanoantenna phosphor 30.

It was found that, when the period P was in a range of 400 nm to 440 nm, a large amount of light was extracted within 30°. Therefore, when the emission angle range of the wavelength-converted light by the antenna array 32 is set to a predetermined range, for example, 30° or less, it is desirable that the period P of the antennas 32A is in a range of 400 nm to 440 nm. It was found that, under conditions other than the above-described period, the region of the diffraction line related to the light extraction is significantly reduced.

That is, it is possible to determine the period P of the antennas 32A on the basis of the emission angle range of the wavelength-converted light by the antenna array 32.

In addition, the antenna array 32 in which the antennas 32A are disposed in a hexagonal lattice has been described. However, the lattice structure of the antenna array 32 is not limited thereto. For example, an antenna array having a periodic structure, such as a square lattice or a triangular lattice, may be used.

### (5) Light Distribution Characteristics of Light-Emitting Device 10

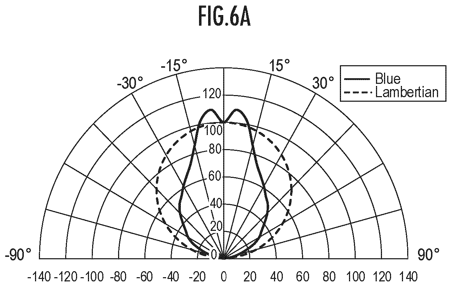

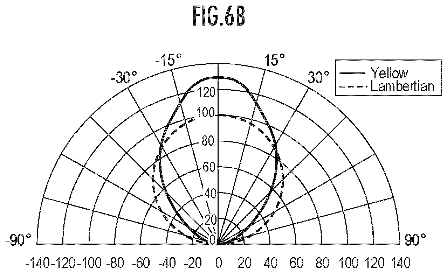

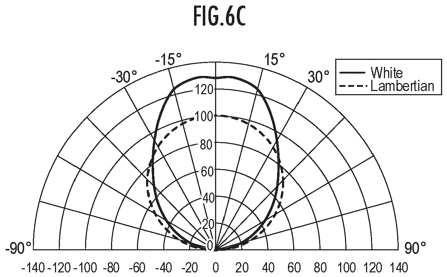

The light distribution characteristics of the light-emitting device 10 will be described below. FIGS. 6A and 6B illustrate the light distribution characteristics of blue light from the LED structure layer 20 and the light distribution characteristics of fluorescence (yellow light) from the nanoantenna phosphor 30, respectively. In addition, FIG. 6C illustrates the light distribution characteristics of white light from the light-emitting device 10, that is, the light distribution characteristics of combined light of the blue light and the fluorescence (yellow light).

In addition, FIGS. 6A to 6C illustrate Lambertian light distribution characteristics (a broken line in FIGS. 6A to 6C) from an LED and a phosphor according to the related art.

As illustrated in FIG. 6A, it is found that, for the blue light from the LED structure layer 20, light corresponding to within ±15° is increased, and a light distribution having a narrower angle than the Lambertian is formed. In addition, as illustrated in FIG. 6B, it is found that there is a function of narrowing the light distribution characteristics of yellow light obtained when the nanoantenna phosphor 30 is excited as compared to the Lambertian.

Further, as illustrated in FIG. 6C, it is found that narrow-angle light distribution characteristics are also obtained for the combined light (white light) from the light-emitting device 10.

More specifically, in the Lambertian light distribution according to the related art, luminous flux (output ratio) within ±30° was 25%. However, in the light-emitting device 10, it was found that the luminous flux within ±30° was 40% and the light distribution was improved by 15% as compared to the Lambertian light distribution. In addition, it was found that center luminance was increased by 20% or more.

That is, narrow-angle white light is capable of being formed for the first time by the combination of the narrow-angle blue light and the narrow-angle yellow light formed by the LED structure layer 20 having the photonic crystal layer 21P and the nanoantenna phosphor 30.

### (6) Mechanism and Configuration of Light-Emitting Device 10

The light-emitting device 10 according to the present invention has been described in detail above. However, the light-emitting device 10 may be configured such that narrow-angle light is formed by the photonic crystal and is efficiently incident on the nanoantenna phosphor.

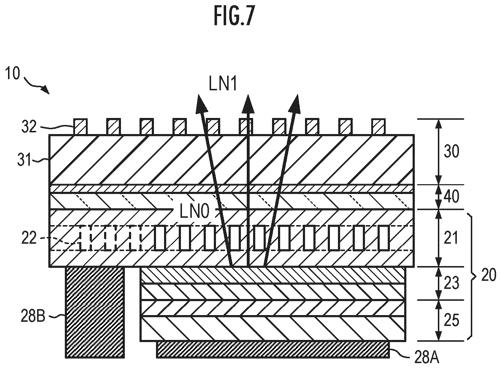

FIG. 7 is a view schematically illustrating the narrow-angle LED light generated by the LED structure layer 20. More specifically, as illustrated in FIG. 7, in the light-emitting device 10 according to the present invention, the LED structure layer 20 is a photonic crystal LED in which the photonic crystal layer 21P is buried and is configured such that the narrow-angle LED light (narrow-angle blue light) is generated.

More specifically, the period of the air holes 22 in the photonic crystal layer 21P is determined according to the incident angle dependence of the reflectivity of the filter film 40A of the optical filter 40. That is, the angle θth at which the reflection angle of the filter film 40A (for example, the dichroic mirror) is 0 (zero) is calculated, and the period of the air holes 22 in the photonic crystal layer 21P is determined such that the diffraction angle θ of the photonic crystal satisfies θ ≤ θth.

That is, the LED structure layer 20 is configured such that narrow-angle light LN0 having the angle θth (in the above-described embodiment, θth = 15°) or less is generated. Then, the narrow-angle light LN0 is transmitted through the optical filter 40, which is an SPF, and is incident on the nanoantenna phosphor 30 with high incidence efficiency.

The wavelength-converted light (yellow light) obtained by the wavelength conversion of the light incident on the phosphor plate 31 of the nanoantenna phosphor 30 by the phosphor is emitted as narrow-angle light LN1 by the nanoantenna 32A. In addition, the wavelength-converted light is reflected in the emission direction by the optical filter 40.

Therefore, narrow-angle white light is emitted by the narrow-angle blue light and the narrow-angle yellow light transmitted through the phosphor plate 31, and the light-emitting device 10 functions as a narrow-angle white light source.

In addition, the case where the photonic crystal layer 21P has a single lattice structure has been described as an example. However, the photonic crystal layer 21P may have a multi-lattice structure such as a double lattice structure.

further, the case where the optical filter 40 is configured by the dichroic mirror has been described as an example. However, the present invention is not limited thereto. The optical filter 40 may be configured as an optical filter, such as a short pass filter (SPF), that transmits the light from the LED structure layer 20 and reflects the wavelength-converted light from the phosphor plate 31.

In this case, the light extraction efficiency is capable of being improved by using the optical filter 40 of which the angle dependence of reflectivity with respect to the light emission from the LED structure layer 20 is small. Specifically, a wide bandpass filter with small incident angle dependence may be used.

### [Second Embodiment]

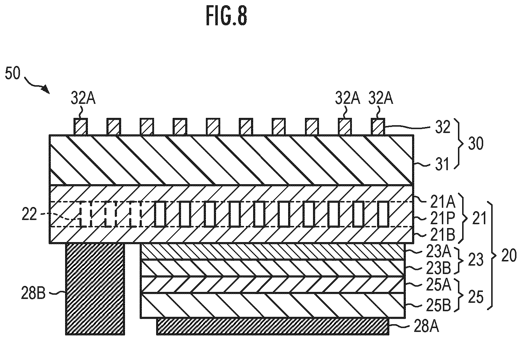

FIG. 8 is a cross-sectional view schematically illustrating a cross-sectional structure of a light-emitting device 50 according to a second embodiment of the present invention.

The light-emitting device 50 according to the second embodiment is different from the light-emitting device 10 according to the first embodiment in that the optical filter 40 is not provided.

More specifically, the light-emitting device 50 includes an LED structure layer 20 and a nanoantenna phosphor 30 disposed on the LED structure layer 20. The LED structure layer 20 and the nanoantenna phosphor 30 have the same configurations as the LED structure layer 20 and the nanoantenna phosphor 30 of the light-emitting device 10 according to the first embodiment.

That is, the LED structure layer 20 is configured to have a photonic crystal layer 21P and to emit predetermined narrow-angle light (for example, within 15° with respect to a normal direction to the LED structure layer 20).

In addition, as described in the light-emitting device 10 according to the first embodiment, the angle of the narrow-angle light is capable of being determined by the arrangement of the air holes in the photonic crystal, the lattice constant a, and the diameter d of the air hole 22.

In the present embodiment, the narrow-angle light from the LED structure layer 20 is directly incident on the nanoantenna phosphor 30. It is preferable that the angle narrowing structure of the nanoantenna phosphor 30 is set according to the angle of the narrow-angle light from the photonic crystal layer 21P.

As described in the light-emitting device 10 according to the first embodiment, the plasmon resonance of the nanoantenna phosphor 30 occurs in conjunction with the diffraction mode. Therefore, the period P of the antennas 32A in the antenna array 32 is capable of being determined by simulating the relationship between the diffraction angle and the wavelength and calculating a region in which light within a predetermined emission angle (for example, 30°) is increased.

A mixed-color light source with narrow-angle light distribution characteristics and high light output is capable of being achieved by the light-emitting device 50 having the above-described configuration.

Further, in the above-described examples, the case where the semiconductor light-emitting structure layer is a photonic crystal light-emitting diode made of a nitride semiconductor has been described. However, the present invention is not limited thereto and is also applicable to photonic crystal light-emitting diodes made of semiconductors of other crystal systems.

In addition, the case where the phosphor plate is made of a phosphor that converts blue light into yellow light has been described. However, the present invention is not limited thereto. A phosphor is capable of being appropriately selected and applied according to, for example, the wavelength of the photonic crystal light-emitting diode to be used.

In addition, the numerical values in the above-described examples are only examples and are capable of being appropriately modified and applied according to the composition of the semiconductor used, the emission wavelength, and the like.

### Description of Reference Numerals

10, 50: light-emitting device
20: semiconductor light-emitting structure layer
21: first semiconductor layer
21P: photonic crystal layer
22: air hole
23: active layer
23A: light-emitting layer
23B: spacer layer
25: second semiconductor layer
28A: p-electrode
28B: n-electrode
30: nanoantenna phosphor
31: phosphor plate
32: antenna array
32A: nanoantenna
40: optical filter
40A: filter film
40B: translucent substrate

## Claims

1. A light-emitting device comprising:
a semiconductor light-emitting structure layer configured to have a photonic crystal layer; and
a nanoantenna phosphor configured to be placed on an emission surface of the semiconductor light-emitting structure layer and to include a wavelength converter configured to convert a wavelength of light emitted from the semiconductor light-emitting structure layer to generate wavelength-converted light and an antenna array configured to have a plurality of nanoantennas periodically arranged on the wavelength converter.

2. The light-emitting device according to claim 1,
wherein the plurality of nanoantennas are arranged with a period that is greater than a peak wavelength of the light emitted from the semiconductor light-emitting structure layer and that is approximately equal to an effective wavelength of the wavelength-converted light in the wavelength converter.

3. The light-emitting device according to claim 1,
wherein the period of the plurality of nanoantennas is set based on an emission angle range of the wavelength-converted light by the antenna array.

4. The light-emitting device according to claim 1,
wherein the semiconductor light-emitting structure layer emits blue light with a peak wavelength in a range of 445 nm to 455 nm,
the wavelength converter converts the wavelength of the light emitted from the semiconductor light-emitting structure layer to generate yellow light, and
the period of the plurality of nanoantennas is in a range of 400 nm to 440 nm.

5. The light-emitting device according to any one of claims 1 to 4, further comprising:
an optical filter configured to be disposed between the semiconductor light-emitting structure layer and the nanoantenna phosphor,
wherein the optical filter transmits the light emitted from the semiconductor light-emitting structure layer and reflects the wavelength-converted light from the nanoantenna phosphor.

6. The light-emitting device according to claim 5,
wherein the optical filter has a transmittance of less than 10% for the emitted light having an incident angle of 30° or more from the semiconductor light-emitting structure layer at a peak wavelength of the emitted light and has a transmittance of 90% or more for the emitted light having an incident angle of 15° or less at the peak wavelength.

7. The light-emitting device according to claim 5,
wherein the semiconductor light-emitting structure layer has a light distribution characteristic in which the light emitted from the semiconductor light-emitting structure layer has a larger number of emitted light components at an angle of 15° or less than that in a Lambertian light distribution characteristic, and
the nanoantenna phosphor has a light distribution characteristic in which light emitted from the nanoantenna phosphor has a larger number of emitted light components at an angle of 15° or less than that in the Lambertian light distribution characteristic.

8. The light-emitting device according to any one of claims 1 to 4,
wherein the wavelength converter is a single-phase phosphor.

9. The light-emitting device according to claim 5,
wherein the wavelength converter is a single-phase phosphor.
